Europäisches Patentamt

European Patent Office

Office européen des brevets

(19)

(11)     **EP 1 258 077 B1**

(12)                    **EUROPÄISCHE PATENTSCHRIFT**

(45) Veröffentlichungstag und Bekanntmachung des
     Hinweises auf die Patenterteilung:
     **17.09.2003   Patentblatt 2003/38**

(51) Int Cl.⁷:  **H03C 1/00**

(21) Anmeldenummer: **00993359.9**

(86) Internationale Anmeldenummer:
     **PCT/DE00/04251**

(22) Anmeldetag: **29.11.2000**

(87) Internationale Veröffentlichungsnummer:
     **WO 01/043275 (14.06.2001 Gazette 2001/24)**

(54) **SCHALTUNGSANORDNUNG ZUR DIREKTMODULATION**

   CIRCUIT CONFIGURATION FOR DIRECT MODULATION

   ENSEMBLE CIRCUIT DE MODULATION DIRECTE

(84) Benannte Vertragsstaaten:
     **DE FR GB**

(30) Priorität: **07.12.1999   DE 19958908**

(43) Veröffentlichungstag der Anmeldung:
     **20.11.2002   Patentblatt 2002/47**

(73) Patentinhaber: **Infineon Technologies AG**
     **81669 München (DE)**

(72) Erfinder: **VEIT, Werner**
     **82008 Unterhaching (DE)**

(74) Vertreter: **Epping Hermann & Fischer**
     **Ridlerstrasse 55**
     **80339 München (DE)**

(56) Entgegenhaltungen:
     **EP-A- 0 800 283           EP-A- 0 893 887**
     **WO-A-94/14247            DE-A- 3 826 882**
     **US-A- 5 179 359          US-A- 5 861 781**

**Beschreibung**

Die Erfindung betrifft eine Schaltungsanordnung zur Direktmodulation, die Oszillatoren, Phasenschiebeeinrichtungen, Mischer und Verknüpfungseinrichtungen aufweist.

In einem Mobilfunksystem wird im Sender das die Nutzinformation enthaltende Basisbandsignal einer hochfrequenten Trägerfrequenz aufmoduliert, um nach geeigneter Verstärkung über die Antenne abgestrahlt zu werden. Zur Umsetzung des Nutzsignals auf die Trägerfrequenz sind eine Vielzahl von unterschiedlichen Modulatoren bekannt.

Bei der Direktmodulation wird das Nutzsignal in Quadraturkomponenten bereitgestellt und mit jeweiligen Quadraturkomponenten der Trägerfrequenz gemischt. Die Summierung der modulierten Quadraturkomponenten ergibt das abzustrahlende Hochfrequenzsignal. Die Trägerfrequenz wird von einem Oszillator geliefert. Dessen Ausgangssignal wird mittels eines Phasenschiebers in um 90° zueinander phasenverschobene Signalkomponenten aufgespalten. Gegebenenfalls sind Teiler in den Signalpfad eingefügt. Die Direktmodulation wird insbesondere bei digitalen zellularen Mobilfunkgeräten angewandt. Vorteilhaft ist die Verwendung nur eines einzigen Oszillators und damit die einfache und kostengünstige Realisierung. Rauschen und außerhalb des erlaubten Frequenzbands liegende Frequenzanteile im Sendesignal werden durch Filter vor der Antenne unterdrückt.

Der Oszillator schwingt abgesehen von der Nutzsignalmodulation auf derselben Frequenz wie das abgestrahlte Signal oder auf einem ganzzahligen Vielfachen davon. Problematisch dabei ist, daß das ausgangsseitig vom Modulator abgegebene Signal in den eingangsseitig liegenden Oszillator parasitär rückgekoppelt wird. Hierbei sind verschiedene Effekte beteiligt, die insbesondere bei Integration auf einem einzigen Halbleiterchip in erhöhtem Maße wirksam sind. Es ist üblich, den Oszillator als Resonanzkreis mit einem aus dem Chip herausgeführten Bonddraht zu realisieren. Der Bonddraht kann einerseits als Empfangsantenne für an anderer Stelle abgestrahlte Hochfrequenzsignale wirken, so daß das Ausgangssignal des Modulators wieder in die Schaltung rückgekoppelt wird. Andererseits kann der Bonddraht des Modulators als Sendeantenne wirken, deren Abstrahlung von Bonddrähten, die zur Zuführung von Versorgungspotentialen dienen, empfangen wird, so daß hierüber eine Rückkopplung in den Modulator erfolgt. Darüber hinaus sind auch Resonanzkreise mit integrierten, planaren Spulen üblich, die genauso als Sender oder Empfänger wirken. Weiterhin bewirken die im Substrat des den Modulator enthaltenden Halbleiterchips fließende Ströme eine Rückkopplung des ausgangsseitigen Signals auf dem eingangsseitigen Oszillator. Der Oszillator ist sehr selektiv, so daß er äußerst empfänglich für eine Einkopplung in seinem durchstimmbaren Frequenzbereich ist.

Wenn das modulierte Ausgangssignal des Direktmodulators auf den eingangsseitigen Oszillator rückgekoppelt wird, wird diese Störung wiederum moduliert; es entsteht ein sog. Remodulationseffekt. Dies hat zur Folge, daß das ausgangsseitige Spektrum verbreitert wird. Das zulässige Frequenzband für die Mobilfunksysteme ist jedoch begrenzt. Innerhalb des erlaubten Frequenzbands ist der jeweilige Sender auf eine oder mehrere Sendekanäle beschränkt. Durch die Aufweitung des Frequenzspektrums aufgrund der Remodulationseffekte besteht die Gefahr, daß Frequenzanteile des Nutzsignals außerhalb des zulässigen Sendekanals liegen können und spezifizierte spektrale Sendemasken verletzt werden. Nachbarkanäle werden dadurch gestört. Remodulationseffekte sind daher zu vermeiden.

In der US 5,861,781 ist ein Quadraturmodulator gezeigt, der ein Einseitenbandsignal erzeugt. Der Modulator enthält einen ersten Abschnitt, in dem das Zwischenfrquenzsignal in orthogonale Komponenten aufgespalten wird, welche mit orthogonalen Komponenten eines hochfrequenten Trägersignals moduliert werden. Die modulierten Komponenten werden anschließend summiert. Das Summensignal wird wiederum in orthogonale Komponenten aufgespalten und mit weiteren I-/Q-Komponenten moduliert. Die so erhaltenen Komponenten werden wiederum summiert, um das Einseitenbandsignal zu erhalten.

Die Aufgabe der Erfindung besteht darin, eine Schaltungsanordnung zur Direktmodulation anzugeben, die einfach realisierbar ist, aber Remodulationseffekte ausreichend sicher vermeidet.

Gemäß der Erfindung wird diese Aufgabe gelöst durch eine Schaltungsanordnung zur Direktmodulation, die umfaßt: einen Oszillator mit einem Ausgang für ein Hochfrequenzsignal; eine erste Phasenschiebeeinrichtung, die eingangsseitig mit dem Ausgang des Oszillators gekoppelt ist und die je einen Ausgang für zueinander phasenverschobene Signale aufweist; einen ersten Mischer und einen zweiten Mischer, die eingangsseitig mit je einem der Ausgänge der Phasenschiebeeinrichtung verbunden sind sowie mit Anschlüssen für zueinander phasenverschobene Signalkomponenten eines Nutzsignals und die je einen Ausgang für ein moduliertes Signal aufweisen; eine Verknüpfungseinrichtung, die eingangsseitig mit den Ausgängen der Mischer verbunden ist und die einen Ausgang zum Abgriff eines mit dem Nutzsignal modulierten Hochfrequenzsignals aufweist; wobei eine zweite Phasenschiebeeinrichtung vorgesehen ist, die eingangsseitig mit dem Ausgang des Oszillators gekoppelt ist und die ausgangsseitig je einen Ausgang für zueinander phasenverschobene Signale aufweist; eine dritte Phasenschiebeeinrichtung, die eingangsseitig mit einem der Ausgänge der zweiten Phasenschiebeeinrichtung verbunden ist und die je einen Ausgang für zueinander phasenverschobene Signale aufweist; einen dritten und einen vierten Mischer, die eingangsseitig mit den Ausgängen der zweiten und dritten Phasenschiebeeinrichtung verbunden sind und die je einen Ausgang für ein moduliertes Signal aufweisen, und eine weitere Verknüpfungseinrichtung, die eingangsseitig mit den Ausgängen der dritten und vierten Mischer verbunden ist und ausgangsseitig an die erste Phasenschiebeeinrichtung angeschlossen ist.

Bei der Direktmodulationsanordnung gemäß der Erfindung schwingt der Oszillator gerade nicht auf einem ganzzahligen Vielfachen der Sendefrequenz. Die Schwingfrequenz des Oszillators ist vielmehr nur ein gebrochen rational Vielfaches der ausgangsseitigen Trägerfrequenz, d.h. die Frequenz des Oszillators ist gegenüber der Ausgangsfrequenz verschoben. Die Rückkopplung ist reduziert, da die Trägerfrequenz außerhalb des Bereichs der höchsten Empfindlichkeit des Oszillators, nämlich dessen momentaner Resonanzfrequenz, liegt. Bei geeigneter Dimensionierung des Frequenzversatzes kann sichergestellt werden, daß trotzdem erzeugte Remodulationsprodukte oder Mischprodukte außerhalb der benachbarten Sendekanäle des Frequenzbandes des Mobilfunksystems liegen. Solche Remodulationsprodukte können problemlos durch die entsprechend gut wirksamen Bandbegrenzungsfilter des Mobilfunkgeräts unterdrückt werden, die ohnehin vorgesehen sind und Frequenzanteile außerhalb des für den Mobilfunkdienst reservierten Frequenzbands unterdrücken. Bei der Herstellung werden die Kosten wesentlich durch den Oszillator bestimmt. Da bei der Schaltung gemäß der Erfindung weiterhin nur ein einziger Oszillator erforderlich ist, bleibt die Herstellung der Direktmodulationsschaltung kostengünstig. Das Ausgangssignal des Direktmodulators wird nach geeigneter Verstärkung an eine Antenne gekoppelt und abgestrahlt.

Die Phasenschieber können als Allpässe ausgeführt werden, die die Frequenz des verarbeiteten Signals nicht ändern. Alternativ können Master-Slave-Flipflops verwendet werden, die eine Teilung durch 2 des Eingangssignals durchführen. Der Abgriff am Ausgang des Slaves des MS-Flipflops liefert eines der Ausgangssignale des Phasenschiebers, beispielsweise das zum Eingangssignal gleichphasige, und in der Frequenz halbierte Ausgangssignal. Der Abgriff am Ausgang des Masters des MS-Flipflops liefert das dazu phasenverschobene Ausgangssignal des Phasenschiebers. Die Ausgangssignale sind Quadraturkomponenten und um 90° zueinander phasenverschoben. Je nach Frequenzbeziehung zwischen Oszillator und Ausgangsträgerfrequenz können alle Phasenschieber als Teiler oder als Allpässe oder als eine Kombination aus beiden ausgeführt werden.

Die Kombination der zweiten und dritten Phasenschieber mit den zweiten und dritten Mischern und der weiteren Verknüpfungseinrichtung bewirken die Verschiebung der Frequenz des Oszillators zur ausgangsseitigen Trägerfrequenz derart, daß diese Frequenzen im Verhältnis eines gebrochen rationalen Vielfachen zueinander liegen. Eine von den Mischern selbst erzeugte Spiegelfrequenz wird durch das Verknüpfungsglied wieder unterdrückt. Wenn den Mischern jeweils Quadraturkomponenten zugeführt werden, die bezogen auf die Ausgänge der Phasenschieber bezüglich der Phasenlage gleichartig sind, wird das untere Seitenband im Summierglied unterdrückt, das obere Seitenband durchgelassen. Wenn den Mischern jeweils Quadraturkomponenten zugeführt werden, die bezogen auf die Ausgänge der Phasenschieber bezüglich der Phasenlage ungleichartig sind, wird das obere Seitenband unterdrückt und das untere Seitenband durchgelassen. Die genannte Kombination bewirkt daher rein eine Verschiebung des ihm eingangsseitig zugeführten Spektrums. Die von den zweiten und dritten Phasenschiebern erzeugten Quadraturkomponenten sind um 90° zueinander phasenverschoben. Je nach Verschaltung der Ausgänge der Phasenschieber an den Mischern wird eines der beiden Seitenbänder hinter dem Summierpunkt unterdrückt. Vertauscht man die Verschaltung der Ausgänge zwischen den Mischern, so wird das andere Seitenband unterdrückt.

Die für die Erfindung zusätzlich benötigten Bauelemente sind herkömmliche Allpässe oder Master-Slave-Flipflops und Mischer sowie ein Summierglied. Der zusätzliche schaltungstechnische Aufwand ist daher mit standardgemäßen Komponenten bei vertretbarem Aufwand realisierbar. Die Schaltung bietet sich daher insbesondere zur Verwendung in einem zellularen digitalen Mobilfunkgerät an.

Nachfolgend wird die Erfindung anhand der in der Zeichnung dargestellten Ausführungsbeispiele näher erläutert. Entsprechende Elemente sind mit gleichen Bezugszeichen versehen. Es zeigen:

Figur 1    einen Direktmodulator gemäß der Erfindung,
Figur 2    ein Ausführungsbeispiel für einen Direktmodulator in einem Tripple-Band-Sender für ein zellulares Mobilfunkgerät und
Figur 3    einen Direktmodulator nach dem Stand der Technik.

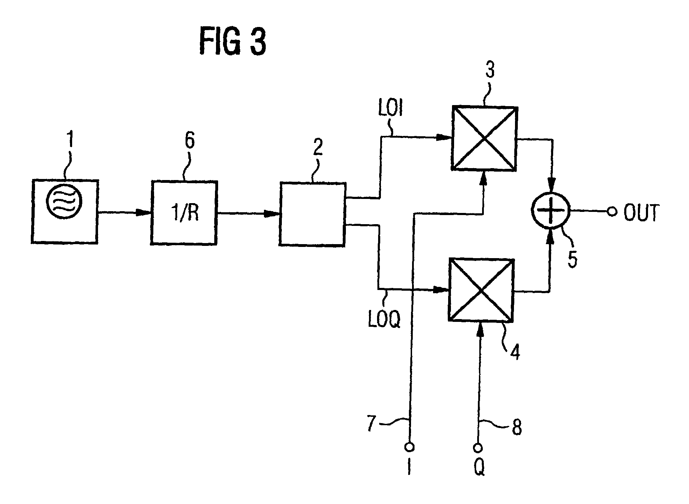

Ein herkömmlicher Direktmodulator gemäß Figur 3 umfaßt einen Hochfrequenzoszillator 1, der auf der gleichen Trägerfrequenz schwingt wie ein Ausgangssignal OUT des Direktmodulators. Der Oszillator 1 ist ein spannungsgesteuerter Oszillator (VCO), der im zulässigen Frequenzband auf eine der Trägerfrequenzen der verfügbaren Sendekanäle abstimmbar ist. Der Oszillator 1 ist auf einem Halbleiterchip integriert, wobei ein Bonddraht, der an einem Pad der integrierten Schaltung herausgeführt wird und an einem anderen Pad wieder zurückgeführt wird, als Resonator dient. Darüber hinaus sind planare Spulen in Form von Metalleiterbahnen als Resonatoren denkbar. Ein Phasenschieber 2 erzeugt aus dem Ausgangssignal des VCO 1 Quadraturkomponenten LOI und LOQ. Die Quadraturkomponenten sind um 90° zueinander phasenverschobene Signale und weisen im Vergleich zur eingangsseitigen Phase eine Phasenlage von 0° bzw. 90° auf. Der Phasenschieber kann als Allpaß realisiert werden, so daß Ausgangs- und Eingangsfrequenz des Phasenschiebers gleich sind. Alternativ bietet sich eine Realisierung als Master-Slave-Flipflop an, bei der das Ausgangssignal die Hälfte der Frequenz des Eingangssignals beträgt. Gegebenenfalls sind Teiler mit beliebigem ganzzahligem Teilerverhältnis möglich. In diesen Fällen sind die Ausgangsfrequenz des Direktmodulators und die Schwingfrequenz des VCO um ein ganzzahliges Vielfaches voneinander verschieden. In einem Mischer 3 wird die eine Quadraturkomponente LOI des Trägersignals mit der einen Quadraturkomponente I des Nutzsignals gemischt. In einem anderen Mischer 4 wird die andere Quadraturkomponente LOQ des Trägersignals mit der anderen Quadraturkomponente Q des Nutzsignals gemischt. Die Signalkomponenten I, Q werden an jeweiligen Anschlüssen 7, 8 bereitgestellt. Die Modulationsprodukte werden in einem Summierer 5 addiert und ergeben das modulierte Ausgangssignal OUT. Gegebenenfalls ist zwischen VCO 1 und Phasenschieber 2 ein Teiler 6 mit einem Teilerfaktor 1/R geschaltet, wobei R die Werte 2, 4, etc. annehmen kann. In diesem Fall ist die Trägerfrequenz des Ausgangssignals OUT ein wiederum anderes Vielfaches der Schwingfrequenz des VCO 1.

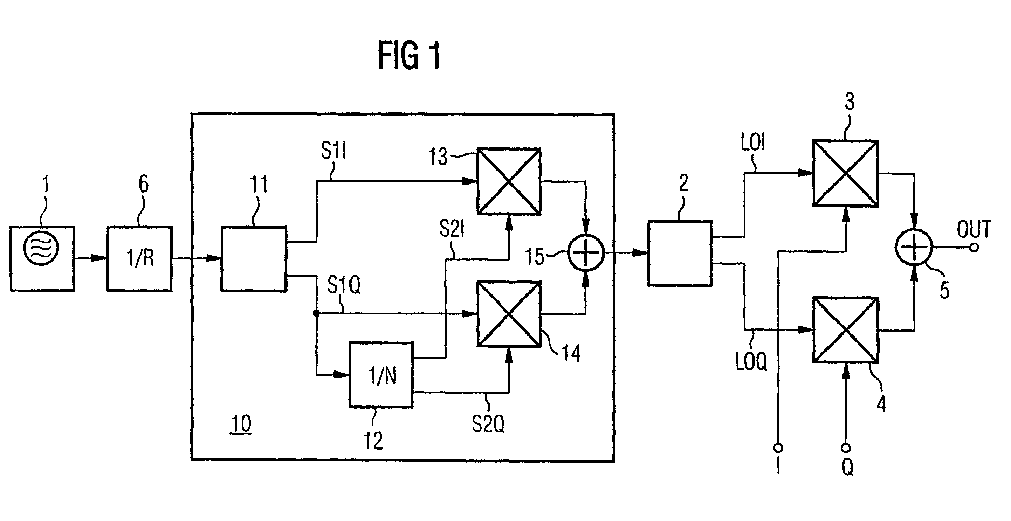

Zusätzlich zu der in Figur 3 gezeigten Schaltung weist der Direktmodulator nach Figur 1 einen Schaltungsblock 10 auf. Eingangsseitig enthält der Schaltungsblock 10 einen zweiten Phasenschieber 11, der mit dem Teiler 6 verbunden ist - oder auch direkt an den VCO 1 angeschlossen werden kann. Der Phasenschieber 11 erzeugt Quadraturkomponenten S1I und S1Q. Ein dritter Phasenschieber 12 wird von einem der Ausgangssignale des zweiten Phasenschiebers 11 gespeist, in Figur 1 vom Signal S1Q. Der dritte Phasenschieber 12 erzeugt wiederum Quadraturkomponenten S2I und S2Q. Der Phasenschieber 12 ist stets ein Teiler durch N. Er enthält Master-Slave-Flipflops. Die null-phasigen Quadraturkomponenten S1I und S2I werden einem dritten Mischer 13 zugeführt. Die bezüglich der jeweiligen Eingangssignale der Phasenschieber 11, 12 um 90° phasenverschobenen Ausgangssignale S1Q, S2Q werden einem vierten Mischer 14 zugeführt. Die an den Ausgängen der Mischer 13, 14 anliegenden Mischprodukte werden in einem Summierer 15 addiert, dessen Ausgangssignal das Eingangssignal des Phasenschiebeglieds 2 bildet.

Die Mischprodukte der Mischer 13, 14 enthalten obere und untere Seitenbänder, von denen eines durch die Summation im Verknüpfungsglied 15 unterdrückt wird. Der Schaltungsblock 10 kann daher als eine Art Spiegelunterdrückungsmischer angesehen werden, sogenannten IMR-Mischer (IMR - image reject). Da nur ein Seitenband vom Schaltungsblock 10 abgegeben wird, ist die Trägerfrequenz des Ausgangssignals des Blocks 10 in Bezug auf die Trägerfrequenz seines Eingangssignals verschoben. Entsprechendes gilt dann für die Frequenz des Ausgangssignals OUT des Modulators bezogen auf die Frequenz des VCO 1. Je nach Verschaltung der Leitungen für S1I, S1Q bzw. S2I, S2Q an den Mischern 13, 14 wird eines der Seitenbänder unterdrückt. Wenn man S1I mit S1Q oder S2I mit S2Q vertauscht, wird das andere Seitenband unterdrückt.

Bei der gezeigten Anordnung ergibt sich für die Beziehung zwischen der Frequenz $f_{OUT}$ des Ausgangssignals OUT und der Frequenz $f_{VCO}$ des Oszillators VCO 1, wenn der Phasenschieber 2 als reiner Phasenschieber, beispielsweise als Allpaß, und der Phasenschieber 11 als Teiler durch 2 ausgeführt ist, folgende Formel:

$$f_{VCO} = \frac{2 \times R \times N}{N + 1} f_{OUT}$$

Wenn den Mischern 13, 14 sowohl I- als auch Q-Signalkomponenten zugeführt werden, wird das untere Seitenband am Ausgang des Schaltungsblocks 10 erzeugt. Beispielsweise werden dem Mischer 13 die Signale S1I und S2Q zugeführt, dem Mischer 14 die Signale S1Q und S2I. Wenn der Phasenschieber 2 ein als Allpaß realisierter Phasenschieber ist, ergibt sich für die Beziehung der Ausgangsfrequenz $f_{OUT}$ zur Frequenz $f_{VCO}$ des VCOs 1 folgende Formel:

$$f_{VCO} = \frac{2 \times R \times N}{N - 1} f_{OUT}$$

Wenn der Phasenschieber 2 kein Allpaß, sondern ein Teiler durch 2 ist, wird die Frequenz des VCO 1 gegenüber der Frequenz $f_{OUT}$ des Ausgangssignals nochmals um den Faktor 2 erhöht. Bemerkenswert ist, daß die Ausgangsfrequenz in Bezug zur Schwingfrequenz des Oszillators ein gebrochen rationales Vielfaches ist, nämlich proportional zu N/(N+1) oder proportional zu N/(N-1).

In Ausgestaltung der Erfindung können die Phasenschieber 2 und 11 unterschiedlich realisiert werden. Es ist entweder ein Allpaß oder ein Teiler durch 2 in Form eines Master-Slave-Flipflops möglich. Der Phasenschieber 12 ist stets ein Teiler in Form eines Master-Slave-Flipflops mit dem Teilfaktor 1/N, wobei N die Werte 2, 4, 8, etc. annehmen kann. Der Teiler 6 ist je nach gewünschtem Frequenzverhältnis optional. Durch verschiedene Kombinationen von Allpässen oder Master-Slave-Flipflops für die Phasenschieber 2, 11 und Teilerfaktoren der Teiler 12, 6 können eine Vielzahl von gebrochen rationalen Frequenzbeziehungen zwischen den Trägerfrequenzen des Ausgangssignals OUT und der Schwingfrequenz des Oszillators 1 erzeugt werden. Die Kombination ist so zu wählen, daß vom Ausgangssignal OUT auf den VCO rückgekoppelte Signalanteile bei der Remodulation durch die Mischer 3, 4 nicht wieder in einem Nutzkanal des für den Mobilfunkdienst zulässigen Frequenzbands liegen. Remodulationsprodukte außerhalb dieses Frequenzbands werden durch hierzu ohnehin vorgesehene Filter mit ausreichender Dämpfung unterdrückt.

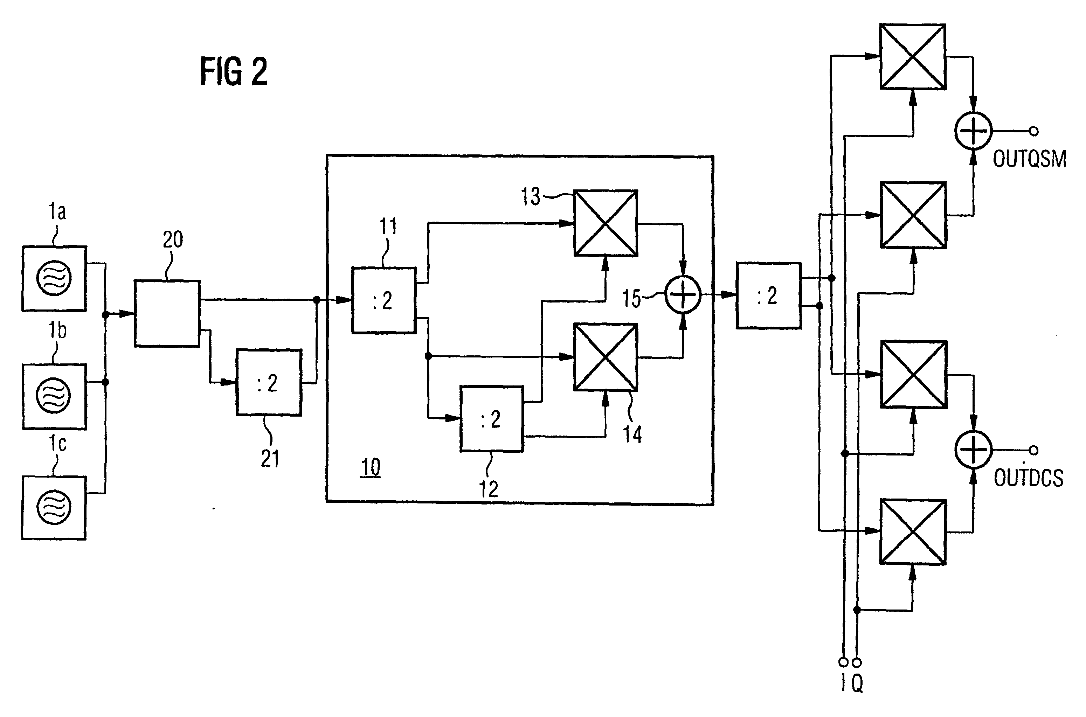

Ein Ausführungsbeispiel für einen Tripple-Band-Sender, der für die Sendefrequenzen der Mobilfunkstandard GSM900, DCS1800 und DCS1900 geeignet ist, ist in Figur 2 dargestellt. Ausgangsseitig sind ein Paar I, Q-Modulatoren für GSM900 vorgesehen sowie wegen der nahe beieinander liegenden Frequenzbänder ein einziges Paar I, Q-Modulatoren für DCS1800 und DCS1900. Der Schaltungsblock 10 weist zwei Master-Slave-Flipflops 10, 11 auf. In den Mischern 13, 14 werden jeweils I- bzw. Q-Signalanteile gemischt. Eingangsseitig sind für jedes Frequenzband VCOs 1a, 1b und 1c vorgesehen. Bei GSM900 wird über einen Multiplexer 20 ein mit 21 bezeichneter Teiler durch 2 in den Signalpfad geschaltet, bei DCS1800/DCS1900 wird der Teiler umgangen. Je nach gewünschtem Frequenzband werden der jeweils zugeordnete Hochfrequenzoszillator 1a, 1b oder 1c und die zugeordneten I, Q-Modulatoren aktiviert. Die gebrochen rationale Frequenzbeziehung der Trägerfrequenz des jeweiligen Ausgangssignals $f_{OUTGSM}$ bzw. $f_{OUTDCS}$ und der jeweils zugeordneten Schwingfrequenz des eingangsseitigen VCO beträgt $f_{VCO} = 2 \times 2 \times 4/3 \times f_{OUTGSM}$ für GSM900 bzw. $f_{VCO} = 2 \times 4/3 \times f_{OUTDCS}$ für DCS1800/DCS1900. Sämtliche relevante Remodulationsprodukte, die sich aus der Rückkopplung der Ausgangssignale OUTGSM und OUTDCS auf die jeweils zugeordneten VCOs 1a, 1b bzw. 1c ergeben, liegen außerhalb der für diese Mobilfunkstandards zulässigen Frequenzbänder. Für GSM900 beispielsweise liegt das Sendefrequenzband zwischen 880...915 MHz, weist also eine Bandbreite von 35 MHz. Die Kanäle sind im Raster von 200 kHz angeordnet. Der VCO 1a ist im Bereich 4693,3...4880,0 MHz durchstimmbar. Sich ergebende Remodulationsprodukte und auch durch die IMR-Schaltung 10 nicht unterdrückte Mischprodukte fallen nicht in das Sendeband und liegen außerhalb der 35 MHz breiten Sendebandbreite. Zweckmäßigerweise sind die VCOs als spannungssteuerbare HF-Oszillatoren mit den übrigen Schaltungskomponenten des Direktmodulators auf einem einzigen Halbleiterchip integriert. Die induktiven Resonatoren sind als Bonddrähte oder planare Spulen realisiert, z.B. als breite Aluminium- oder Kupferbahnen. Um den Durchstimmbereich und damit das Rauschen jedes VCO minimal zu halten wurde für jedes Band ein separater Oszillator gewählt, denkbar wäre auch ein einzelner Oszillator mit entsprechend großem Durchstimmbereich.

**Patentansprüche**

1. Schaltungsanordnung zur Direktmodulation, die umfaßt:

   - einen Oszillator (1) mit einem Ausgang für ein Hochfrequenzsignal,
   - eine erste Phasenschiebeeinrichtung (2), die eingangsseitig mit dem Ausgang des Oszillators (1) gekoppelt ist und die je einen Ausgang für zueinander phasenverschobene Signale (LOI, LOQ) aufweist,
   - einen ersten Mischer (3) und einen zweiten Mischer (4), die eingangsseitig mit je einem der Ausgänge der Phasenschiebeeinrichtung (2) verbunden sind sowie mit Anschlüssen für zueinander phasenverschobene Signalkomponenten (I, Q) eines Nutzsignals und die je einen Ausgang für ein moduliertes Signal aufweisen,
   - eine Verknüpfungseinrichtung (5), die eingangsseitig mit den Ausgängen der Mischer (3, 4) verbunden ist und die einen Ausgang zum Abgriff eines mit dem Nutzsignal modulierten Hochfrequenzsignals (OUT) aufweist,
   - eine zweite Phasenschiebeeinrichtung (11), die eingangsseitig mit dem Ausgang des Oszillators (1) gekoppelt ist und die ausgangsseitig je einen Ausgang für zueinander phasenverschobene Signale (S1I, S1Q) aufweist,
   - eine dritte Phasenschiebeeinrichtung (12), die eingangsseitig mit einem der Ausgänge der zweiten Phasenschiebeeinrichtung (11) verbunden ist und die je einen Ausgang für zueinander phasenverschobene Signale (S2I, S2Q) aufweist,
   - einen dritten und einen vierten Mischer (13, 14), die eingangsseitig mit den Ausgängen der zweiten und dritten Phasenschiebeeinrichtung (11, 12) verbunden sind und die je einen Ausgang für ein moduliertes Signal aufweisen, und
   - eine weitere Verknüpfungseinrichtung (15), die eingangsseitig mit den Ausgängen der dritten und vierten Mischer (13, 14) verbunden ist und ausgangsseitig an die erste Phasenschiebeeinrichtung (2) angeschlossen ist.

2. Schaltungsanordnung zur Direktmodulation nach Anspruch 1,
   **dadurch gekennzeichnet, daß**
   zwischen dem Ausgang des Oszillators (1) und dem Eingang der ersten Phasenschiebeeinrichtung (2) ein Teiler (6, 21) geschaltet ist.

3. Schaltungsanordnung zur Direktmodulation nach Anspruch 1 oder 2,
   **dadurch gekennzeichnet, daß**
   die Phasenschiebeeinrichtungen (2, 11, 12) ausgebildet sind, Ausgangssignale zu erzeugen, die um eine Phase von 90° zueinander phasenverschoben sind.

4. Schaltungsanordnung zur Direktmodulation nach Anspruch 3,

**dadurch gekennzeichnet, daß**
mindestens eine der Phasenschiebeeinrichtungen (2, 11, 12) ein Master-Slave-Flipflop umfaßt und daß einer der Ausgänge dieser Phasenschiebeeinrichtung durch den Ausgang des Masters gebildet ist und ein anderer der Ausgänge dieser Phasenschiebeeinrichtung durch den Ausgang des Slaves gebildet ist.

5. Schaltungsanordnung zur Direktmodulation nach Anspruch 3,
**dadurch gekennzeichnet, daß**
mindestens eine der Phasenschiebeeinrichtungen (2, 11) ein Allpaß ist.

6. Schaltungsanordnung nach einem der Ansprüche 1 bis 5,
**dadurch gekennzeichnet, daß**
die dritte Phasenschiebeeinrichtung (12) ein Teiler ist.

7. Schaltungsanordnung zur Direktmodulation nach einem der Ansprüche 1 bis 6,
**dadurch gekennzeichnet, daß**
der dritte und vierte Mischer (13, 14) eingangsseitig jeweils mit einem Ausgang der zweiten Phasenschiebeeinrichtung (11) und mit einem Ausgang der dritten Phasenschiebeeinrichtung (12) verbunden sind.

8. Schaltungsanordnung zur Direktmodulation nach Anspruch 7,
**dadurch gekennzeichnet, daß**
die zweite und dritte Phasenschiebeeinrichtung (11, 12) je einen gleichphasigen Ausgang aufweist, dessen Ausgangssignal zum jeweiligen Eingangssignal gleiche Phasenlage aufweist, und einen phasenverschobenen Ausgang, dessen Ausgangssignal zum jeweiligen Eingangssignal um 90° verschobene Phasenlage aufweist, und daß der dritte Mischer (13) eingangsseitig mit den gleichphasigen Ausgängen der zweiten und dritten Phasenschiebeeinrichtungen (11, 12) verbunden ist und daß der vierte Mischer (14) eingangsseitig mit den phasenverschobenen Ausgängen der zweiten und dritten Phasenschiebeeinrichtungen (11, 12) verbunden ist.

9. Schaltungsanordnung zur Direktmodulation nach Anspruch 7,
**dadurch gekennzeichnet, daß**
die zweite und dritte Phasenschiebeeinrichtung (11, 12) je einen gleichphasigen Ausgang aufweist, dessen Ausgangssignal zum Eingangssignal jeweils gleiche Phasenlage aufweist, und einen phasenverschobenen Ausgang, dessen Ausgangssignal zum jeweiligen Eingangssignal um 90° verschobene Phasenlage aufweist, und daß der dritte und der vierte Mischer (13, 14) eingangsseitig jeweils mit einem gleichphasigen Ausgang und einem gegenphasigen Ausgang der zweiten und dritten Phasenschiebeeinrichtungen (11, 12) verbunden ist.

10. Schaltungsanordnung zur Direktmodulation nach einem der Ansprüche 1 bis 9,
**gekennzeichnet durch**
Verwendung in einem zellularen digitalen Mobilfunkgerät, bei dem der Ausgang der Verknüpfungseinrichtung (5) über eine Verstärkereinrichtung an eine Antenne gekoppelt ist.

**Claims**

1. Circuit arrangement for direct modulation, which comprises:

   - an oscillator (1) having an output for a radiofrequency signal,
   - a first phase shifting device (2), which, on the input side, is coupled to the output of the oscillator (1) and which has a respective output for mutually phase-shifted signals (LOI, LOQ),
   - a first mixer (3) and a second mixer (4), which, on the input side, are connected to a respective one of the outputs of the phase shifting device (2) and also to terminals for mutually phase-shifted signal components (I, Q) of a useful signal and which each have an output for a modulated signal,
   - a combination device (5) which, on the input side, is connected to the outputs of the mixers (3, 4) and which has an output for tapping off a radiofrequency signal (OUT) modulated with the useful signal,
   - a second phase shifting device (11), which, on the input side, is coupled to the output of the oscillator (1) and which, on the output side, has a respective output for mutually phase-shifted signals (S1I, S1Q),
   - a third phase shifting device (12), which, on the input side, is connected to one of the outputs of the second phase shifting device (11) and which has a respective output for mutually phase-shifted signals (S2I, S2Q),
   - a third and a fourth mixer (13, 14), which, on the input side, are connected to the outputs of the second and third phase shifting devices (11, 12) and which each have an output for a modulated signal, and
   - a further combination device (15), which, on the input side, is connected to the outputs of the third and fourth mixers (13, 14) and, on the output side, is connected to the first phase shifting device (2).

**2.** Circuit arrangement for direct modulation according to Claim 1,
**characterized in that**
a divider (6, 21) is connected between the output of the oscillator (1) and the input of the first phase shifting device (2).

**3.** Circuit arrangement for direct modulation according to Claim 1 or 2,
**characterized in that**
the phase shifting devices (2, 11, 12) are designed to generate output signals which are phase-shifted by a phase of 90° with respect to one another.

**4.** Circuit arrangement for direct modulation according to Claim 3,
**characterized in that**
at least one of the phase shifting devices (2, 11, 12) comprises a master-slave flip-flop, and **in that** one of the outputs of this phase shifting device is formed by the output of the master and another of the outputs of this phase shifting device is formed by the output of the slave.

**5.** Circuit arrangement for direct modulation according to Claim 3,
**characterized in that**
at least one of the phase shifting devices (2, 11) is an all-pass network.

**6.** Circuit arrangement according to one of Claims 1 to 5,
**characterized in that**
the third phase shifting device (12) is a divider.

**7.** Circuit arrangement for direct modulation according to one of Claims 1 to 6,
**characterized in that**
the third and fourth mixers (13, 14) are in each case connected, on the input side, to an output of the second phase shifting device (11) and to an output of the third phase shifting device (12).

**8.** Circuit arrangement for direct modulation according to Claim 7,
**characterized in that**
the second and third phase shifting devices (11, 12) each have an in-phase output, whose output signal has the same phase angle as the respective input signal, and a phase-shifted output whose output signal has a phase angle shifted by 90° relative to the respective input signal, and **in that** the third mixer (13) is connected on the input side, to the in-phase outputs of the second and third phase shifting devices (11, 12), and **in that** the fourth mixer (14) is connected, on the input side, to the phase-shifted outputs of the second and third phase shifting devices (11, 12).

**9.** Circuit arrangement for direct modulation according to Claim 7,
**characterized in that**
the second and third phase shifting devices (11, 12) each have an in-phase output, whose output signal in each case has the same phase angle as the input signal, and a phase-shifted output, whose output signal has a phase angle shifted by 90° relative to the respective input signal, and **in that** the third and fourth mixers (13, 14) are in each case connected, on the input side, to an in-phase output and an in-antiphase output of the second and third phase shifting devices (11, 12).

**10.** Circuit arrangement for direct modulation according to one of Claims 1 to 9,
**characterized by**
use in a cellular digital mobile radio unit in which the output of the combination device (5) is coupled to an antenna via an amplifier device.

**Revendications**

**1.** Agencement de circuit pour la modulation directe, qui comprend

- un oscillateur (1) ayant une sortie pour un signal haute fréquence,
- un premier dispositif de décalage de phase (2), qui, côté entrée, est couplé à la sortie de l'oscillateur (1) et qui présente une sortie respective pour des signaux (LOI, LOQ) réciproquement déphasés,
- un premier mélangeur (3) et un second mélangeur (4) qui, côté entrée, sont reliés chacun respectivement à l'une des sorties du dispositif de décalage de phase (2) et présentent des bornes respectives pour des composantes de signal (I, Q) réciproquement déphasées, d'un signal utile, et qui comportent chacun une sortie pour un signal modulé,
- un dispositif logique de combinaison (5) qui, côté entrée, est relié aux sorties des mélangeurs (3, 4), et qui comporte une sortie destinée au prélèvement d'un signal haute fréquence (OUT) modulé avec le signal utile,
- un second dispositif de décalage de phase (11) qui, côté entrée, est couplé à la sortie de l'oscillateur (1), et qui, côté sortie, présente une sortie respective pour des signaux (S1I, S1Q) réciproquement déphasés,
- un troisième dispositif de décalage de phase (12) qui, côté entrée, est relié à l'une des sorties du second dispositif de décalage de phase (11), et qui, côté sortie, présente une sortie respective pour des signaux (S2I, S2Q) réciproquement déphasés,

   -   un troisième et un quatrième mélangeur (13, 14) qui, côté entrée, sont reliés aux sorties du second et du troisième dispositifs de décalage de phase (11, 12) et qui présentent chacun une sortie pour un signal modulé, et

   -   un autre dispositif logique de combinaison (15), qui, côté entrée, est relié aux sorties du troisième et quatrième mélangeurs (13, 14), et est raccordé, côté sortie, au premier dispositif de décalage de phase (2).

2. Agencement de circuit pour la modulation directe selon la revendication 1, **caractérisé en ce qu'**entre la sortie de l'oscillateur (1) et l'entrée du premier dispositif de décalage de phase (2), est monté un diviseur (6, 21).

3. Agencement de circuit pour la modulation directe selon la revendication 1 ou 2, **caractérisé en ce que** les dispositifs de décalage de phase (2, 11, 12) sont conçus pour produire des signaux de sortie qui sont mutuellement décalés en phase d'une valeur de phase de 90°.

4. Agencement de circuit pour la modulation directe selon la revendication 3, **caractérisé en ce que** l'un au moins des dispositifs de décalage de phase (2, 11, 12) comprend une bascule ou flip-flop maître-esclave, et **en ce que** l'une des sorties de ce dispositif de décalage de phase est formée par la sortie maître et une autre des sorties de ce dispositif de décalage de phase est formée par la sortie esclave.

5. Agencement de circuit pour la modulation directe selon la revendication 3, **caractérisé en ce que** l'un au moins des dispositifs de décalage de phase (2, 11, 12) est un dispositif pour toutes les fréquences.

6. Agencement de circuit pour la modulation directe selon l'une des revendications 1 à 5, **caractérisé en ce que** le troisième dispositif de décalage de phase (12) est un diviseur.

7. Agencement de circuit pour la modulation directe selon l'une des revendications 1 à 6, **caractérisé en ce que** le troisième et le quatrième mélangeurs (13, 14) sont reliés, côté entrée, respectivement à une sortie du second dispositif de décalage de phase (11) et à une sortie du troisième dispositif de décalage de phase (12).

8. Agencement de circuit pour la modulation directe selon la revendication 7, **caractérisé en ce que** le second et le troisième dispositifs de décalage de phase (11, 12) présentent chacun une sortie de même phase, dont le signal de sortie présente la même position de phase relativement au signal d'entrée respectif, et une sortie décalée en phase, dont le signal de sortie présente une position de phase décalée de 90° par rapport au signal d'entrée respectif, et **en ce que** le troisième mélangeur (13) est relié, côté entrée, aux sorties de même phase des second et troisième dispositifs de décalage de phase (11, 12), et **en ce que** le quatrième mélangeur (14) est relié, côté entrée, aux sorties décalées en phase des second et troisième dispositifs de décalage de phase (11, 12).

9. Agencement de circuit pour la modulation directe selon la revendication 7, **caractérisé en ce que** le second et le troisième dispositifs de décalage de phase (11, 12) présentent chacun une sortie de même phase, dont le signal de sortie présente la même position de phase relativement au signal d'entrée, et une sortie décalée en phase, dont le signal de sortie présente une position de phase décalée de 90° par rapport au signal d'entrée respectif, et **en ce que** le troisième et le quatrième mélangeurs (13, 14) sont reliés, côté entrée, respectivement à une sortie de même phase et une sortie en opposition de phase des second et troisième dispositifs de décalage de phase (11, 12).

10. Agencement de circuit pour la modulation directe selon l'une des revendications 1 à 9, **caractérisé par** une utilisation dans un appareil de radiocommunications mobile, numérique, cellulaire, dans lequel la sortie du dispositif logique de combinaison (5) est couplée à une antenne par l'intermédiaire d'un dispositif amplificateur.

FIG 1

FIG 2

EP 1 258 077 B1

# FIG 3